# EUROPEAN PATENT SPECIFICATION

(11) **EP 4 063 809 B1**
(45) Date of publication and mention of the grant of the patent: **02.12.2026**
(21) Application number: 21164273.1
(22) Date of filing: 23.03.2021
(51) Int. Cl.: G01J 5/06, G01J 5/061, G01J 5/28, H04N 23/23, H10F 30/221, H10F 77/123, H04N 5/33

(54) **METHOD FOR INSPECTING AN ARTICLE MANUFACTURING PROCESS**
VERFAHREN ZUR ÜBERPRÜFUNG EINES PRODUKTIONSPROZESSES VON ARTIKELN
PROCÉDÉ D'INSPECTION D'UN PROCÉDÉ DE FABRICATION D'UN ARTICLE

(43) Date of publication of application: 28.09.2022
(73) Proprietor: The Procter & Gamble Company, Cincinnati, OH 45202 (US)
(72) Inventor: VARGA, Stephen Michael, Cincinnati, OH 45202 (US); MERSCH, Steven Henry, Germantown, OH 45327 (US)
(74) Representative: P&G Patent Germany

(56) References cited:
- JP-A- 2011 119 398
- US-A- 5 449 908
- US-A1- 2009 134 333
- US-A1- 2011 141 269
- US-A1- 2015 290 047
- US-A1- 2020 309 604
- US-B1- 6 515 285
- FRASSE-SOMBET S ET AL: "The lowest cost and smallest footprint VGA SWIR detector with high performance", SPIE PROCEEDINGS; [PROCEEDINGS OF SPIE ISSN 0277-786X], SPIE, US, vol. 11002, 7 May 2019 (2019-05-07), pages 1100215 - 1100215, XP060122012, ISBN: 978-1-5106-3673-6, DOI: 10.1117/12.2522104
- ANONYMOUS: "Now available: Allied Vision's new affordable InGaAs camera models for short-wave infrared (SWIR) - Allied Vision", 24 April 2018 (2018-04-24), Internet, XP093265647, Retrieved from the Internet <URL:https://www.alliedvision.com/en/news/detail/now-available-allied-visions-new-affordable-ingaas-camera-models-for-short-wave-infrared-swir/> [retrieved on 20250401]

## Description

### FIELD OF THE INVENTION

The present disclosure relates to methods for inspecting manufacturing processes, more particularly, methods for inspecting manufacturing processes using high-speed thermal radiation detection, and even more particularly, methods comprising thermal radiation detection systems.

### BACKGROUND OF THE INVENTION

Along an assembly line, absorbent articles may be assembled by adding components to and otherwise modifying an advancing, continuous web of material. For example, in some processes, advancing webs of material are combined with other advancing webs of material. In other examples, individual components created from advancing webs of material are combined with advancing webs of material, which in turn, are then combined with other advancing webs of material. Webs of material and component parts used to manufacture absorbent articles, such as diapers, may include: backsheets, topsheets, absorbent cores, front and/or back ears, fastener components, and various types of elastic webs and components such as leg elastics, barrier leg cuff elastics, and waist elastics. Once the desired component parts are assembled, the advancing web(s) and component parts are subjected to a final knife cut to separate the web(s) into discrete diapers or other absorbent articles. The discrete diapers or other absorbent articles may also then be folded and packaged.

For quality control purposes, absorbent article converting lines, packaging lines, or industrial automation machinery or processes may utilize various types of sensor technology to inspect the webs and discrete components added, transformed, or manipulated within the process. Example sensor technology may include vision systems, photoelectric sensors, proximity sensors, laser or sonic distance detectors, and the like. Product inspection data from the sensors may be communicated to a controller in various ways. In turn, the controller may be programmed to receive product inspection data, and in turn, make adjustments to the manufacturing process. In some instances, the controller may reject defective absorbent articles based on the product inspection data after the final knife cut at the end of the converting line.

In addition, manufacturing processes may utilize various types of sensor technology to monitor the performance of various types of assembly equipment used in the industrial process. Example process sensor technology may include speed sensors, linear or radial position sensors, temperature, pressure or vacuum sensors, vision systems, proximity sensors, and the like. Process data from the process sensors may be communicated to a controller in various ways. In turn, the controller may be programmed to receive process data, and in turn, make adjustments to the manufacturing process and/or communicate potential problems associated with assembly equipment to technicians or operators. In some instances, based on the process data, the controller may automatically shutdown the process.

Some absorbent article converting lines, assembly processes, industrial processes, or equipment may utilize infrared sensors to monitor performance, or otherwise provide operational feedback regarding the webs, discrete components, or other equipment or processes. There are thermal type infrared sensors (e.g., pyroelectric elements or thermopiles) that employ temperature changes generated by the absorption of infrared energy, and quantum type infrared sensors that employ changes in conductivity, or in electromotive force, voltage, or current, that are generated by electrons excited by incident photons. The thermal type, however, which can be operated at room temperature, has disadvantages in that it requires broad-band wavelength exposure (typically more than 4 microns) and a low sensitivity and in that its response speed is slow. Due to the low sensitivity and slow response speed, these type of sensors are not typically adequate for use in monitoring higher speed manufacturing processes. On the other hand, the quantum type, although it must be cooled to extremely low temperatures, has characteristics such as requiring less broad-band wavelength exposure (typically less than 4 microns) and high sensitivity and high response speed. Many quantum type sensors must be cooled using liquid nitrogen or liquid helium or by using electronic cooling, such as using a Stirling cooler for example, in order to provide reduce nose and achieve the desired sensitivity. In some instances, these types of sensors must be cooled to about -200° Celsius. Cooling the entire sensor requires the overall form factor to be increased, and accordingly, makes it challenging, if not impractical, to incorporate such sensors into small spaces. In many cases, positioning such sensors proximate to a manufacturing system to verify a manufacturing process via an infrared signal is not feasible due to the confines of the surrounding machinery, in addition to other limitations. The cooling requirements require more energy in addition to space. The cooling components consume additional power, and in turn, generate additional thermal noise which must be directed, contained, or transported away. Therefore, there is a need for systems and methods for providing infrared sensing for manufacturing systems with the sensing have the desired response speed and form factor.

For some non-industrial applications, such as vehicle, pedestrian, or object collision avoidance, detection, tracking, or monitoring; some applications require sensors which are both fast and able to operate at ambient temperature. The cooling requirements for such applications prohibits practicality for many of the same reasons as industrial applications, namely cost, speed, size, and power consumption.

< US 2009/0134333 A1 relates to an infrared sensor comprising: a light receiving unit that includes a quantum type infrared detection element and that converts the energy of the infrared rays to an electrical signal. The sensor further comprises a correction unit formed of the identical material on the identical substrate as the light receiving unit.

US 5449908 A is concerned a method of processing infrared signals via a hybrid semiconductor imaging system with the optically sensitive components located on a infrared imaging substrate and the signal processing components located on a separate signal conditioning substrate.

US 6515285 B1 discloses methods and an apparatus for compensating a radiation sensor for ambient temperature variations. The compensation can be done by adding an offset to a sensor bias voltage or a sensor bias current, and/or controlling a temperature of the radiation sensor. For this, a radiation sensor array, a temperature controller and a temperature sensitive reference circuit are enclosed in one package.

US 2011/0141269 A1 relates to systems and methods for manufacturing disposable absorbent articles and more in particular to methods and apparatuses for monitoring on-line webs using line scan cameras. In order to achieve a constant machine direction pixel resolution a line trigger signal may indicate necessary a temporal frequency of camera image captures. >

### SUMMARY OF THE INVENTION

According to the invention, a method for inspecting an article manufacturing process is provided as defined in claim 1. Further developments of the invention are defined by the dependent claims.

In one form, not encompassed by the wording of the claims, a thermal radiation detection system comprises a plurality of infrared sensor elements arranged as an array, wherein each of the plurality of infrared sensor elements comprises a semiconductor selected from a mercury-cadmium-telluride (HgCdTe)-based photodiode infrared detector, or an Indium Arsenide (InAs)-based photodiode infrared detector, configured to generate an output responsive to detected mid-infrared wavelengths. The thermal radiation detection system may also comprises an amplifier circuit, the amplifier circuit being configured to convert the current outputs from the plurality of infrared sensor elements to output voltages. The thermal radiation detection system also comprises a temperature sensing circuit, the temperature sensing circuit being configured to generate signals correlated to temperatures of one or more of the plurality of infrared sensor elements. The thermal radiation detection system also comprises a signal processing circuit, the signal processing circuit configured to generate a signal usable by an imaging system based on the signals generated by the temperature sensing circuit and the output voltages from the amplifier circuit or infrared sensor elements. The signals generated by the temperature sensing circuit is used to correct for noise or drift from the signals generated by the infrared sensor elements or their associated amplifier. The correction can be a linear or non-linear correction, depending on the characterization of signals. In some embodiments, the corrections are look up tables corresponding to known experimental or historical conditions.

The electrodes connected to the infrared sensor elements are arranged such that the connections are not on the same surface as the incident infrared energy allowing a larger proportion of the surface to receive energy unimpeded by connection terminals. The larger proportion of the exposed surface increases the efficiency and signal-to-noise rations and therefore improving the speed and sensitivity of the detection elements.

The improved signal-to-noise ratio of the infrared sensor elements allows the system to be operated at ambient temperature. Ambient temperature for some field conditions would be above 0 °C and below 55 °C. Preferably ambient temperature is defined as between 5 °C and 25 °C. The ambient temperature for some field conditions may be raised due to proximity to other items such as motors, heaters, CPUs, or generators. The ambient temperature for some field conditions may be lowered due to proximity to other items such forced or entrained fluid or air movement.

In another form, a thermal radiation detection system comprises a first mercury-cadmium-telluride (HgCdTe)-based or an Indium Arsenide (InAs)-based photodiode infrared detector configured to generate a first output responsive to detected infrared wavelengths and a first transimpedance amplifier to convert the current output from the first HgCdTe-based or InAs-based photodiode infrared detector to an output voltage. The thermal radiation detection system also comprises a first temperature sensing device positioned proximate to the first HgCdTe-based or InAs-based photodiode infrared detector, the first temperature sensing device to generate a signal correlated to temperature. The thermal radiation detection system also comprises a signal processing circuit, the signal processing circuit configured to generate a signal based on the signal generated by the first temperature sensing circuit and the output voltage from the first transimpedance amplifier.

In another form, according to an aspect of the invention, a method for inspecting an article manufacturing process comprises positioning a thermal radiation detection system proximate to a manufacturing process, advancing an article past the plurality of infrared sensor elements subsequent to the manufacturing process, and identifying characteristics of the manufacturing process based on the signal from the signal processing circuit.

### BRIEF DESCRIPTION OF THE DRAWINGS

The above-mentioned and other features and advantages of the present disclosure, and the manner of attaining them, will become more apparent, and the disclosure itself will be better understood, by reference to the following description of non-limiting embodiments of the disclosure taken in conjunction with the accompanying drawings, wherein:
FIG. 1 schematically depicts a thermal radiation detection system in accordance with a non-claimed example embodiment.
FIG. 2 schematically depicts another thermal radiation detection system in accordance with non-claimed example embodiment.
FIG. 3 provides a simplified view of an infrared sensor element in accordance with a non-claimed example embodiment.
FIG. 4 depicts a portion of an example thermal radiation detection system.
FIG. 5 schematically depicts a thermal radiation detection system having an array of infrared sensor elements.
FIG. 6 schematically depicts a thermal radiation detection system having an array of infrared sensor elements.
FIG. 7 schematically illustrates the placement of a plurality of arrays, each of which comprises infrared sensor elements arranged linearly.
FIG. 8 is a simplified isometric view of an article moving in a machine direction (MD) relative to a linear array of infrared sensor elements.
FIG. 9 is a simplified isometric view of another article moving in a machine direction (MD) relative to a plurality of linear arrays, each of which includes a plurality of infrared sensor elements.
FIG. 10 schematically depicts a simplified manufacturing process incorporating an example thermal radiation detection system.
FIG. 11 is a simplified thermal radiation detection system that is configured as a spectroscopy sensor device.

### DETAILED DESCRIPTION OF THE INVENTION

The present disclosure relates to high speed infrared sensor systems and methods thereof. Various nonlimiting embodiments of the present disclosure will now be described to provide an overall understanding of the principles of the function, design and operation of the systems and methods. One or more examples of these nonlimiting embodiments are illustrated in the accompanying drawings. Those of ordinary skill in the art will understand that the systems and methods described herein and illustrated in the accompanying drawings are nonlimiting example embodiments and that the scope of the various nonlimiting embodiments of the present disclosure are defined solely by the claims. The features illustrated or described in connection with one nonlimiting embodiment may be combined with the features of other nonlimiting embodiments. Such modifications and variations are intended to be included within the scope of the present disclosure.

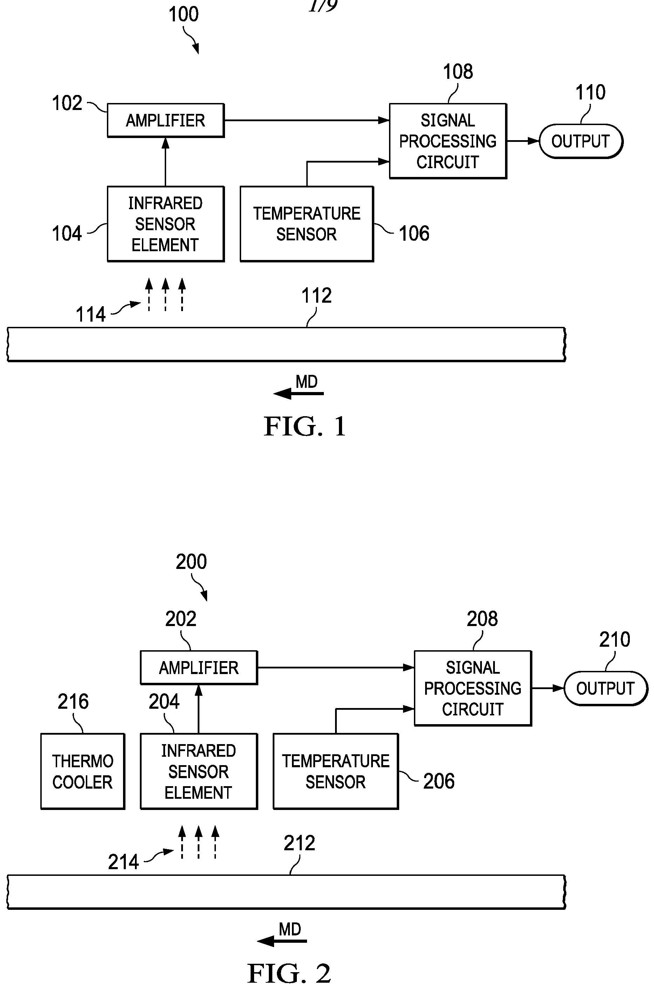

FIG. 1 schematically depicts a thermal radiation detection system 100 in accordance with an example embodiment. Various components of the thermal radiation detection system 100 can be positioned proximate to an article 112 in order to detect incident infrared radiation, schematically depicted as infrared radiation 114. The article 112 can comprise, for example, any of a web, a substrate, a bottle, a package, a component of machinery, an elastic, an adhesive, an absorbent gelling material (AGM), a printing, a chemical additive, a lotion, and a volatile composition. The infrared radiation 114 can be used to assess the quality or other characteristic of a manufacturing process, such as an application of an adhesive to the article 112, seaming of the article 112, heat bonding the article 112, pressure welding the article 112, cohesive bonding the article 112, and so forth.

The thermal radiation detection system 100 can include at least one infrared sensor element 104 that is positioned proximate to a temperature sensor 106. The temperature sensor 106 can be any suitable sensing device, such as a negative temperature coefficient thermistor, a thermocouple, a photodiode sensitive to infrared energy, or a resistance temperature detector, for example. Responsive to the detected infrared radiation 114, the infrared sensor element 104 can provide an output to an amplifier 102. The amplifier 102 can convert the current output from the infrared sensor element 104 to an output voltage. The amplifier 102 can be any suitable application, and in some embodiments, is implemented as a transimpedance amplifier (TIA).

A signal processing circuit 108 can receive the output voltage from the amplifier 102 along with a signal from the temperature sensor 106. The signal processing circuit 108 can, in turn, generate an output signal 110 that can be usable by an imaging system, or other suitable system. In some embodiments, the signal processing circuit 108 is an application-specific integrated circuit (ASIC), a field programmable gate array (FPGA), a central processing unit (CPU), or a graphics processing unit (GPU). In some embodiments, the signal processing circuit 108 is a virtualized ASIC, FPGA, CPU, or GPU on a network, internet cloud, or other virtualized computing platform.

The amplifier 102 may be integrated with the signal processing circuit 108 or may be after the signal processing circuit 108.

The infrared sensor element 104 can comprise photodiode infrared detector comprising a semiconductor, wherein the semiconductor is selected from mercury-cadmium-telluride also referred to as an MCT, or indium arsenide or combinations thereof. The infrared sensor element can comprise a mercury-cadmium-telluride (HgCdTe)-based photodiode infrared detector, or an Indium Arsenide (InAs)-based photodiode infrared detector, that is configured to generate an output responsive to detected infrared wavelengths. Such detected wavelengths of infrared radiation can be usable for inspection purposes, quality control, and so forth. In some embodiments, the detected infrared wavelengths are about 4microns to about 14microns, for example, specifically reciting all 0.5 micron increments within the above-recited range and all ranges formed therein or thereby. The temperature sensor 106 can be a component of a temperature sensing circuit of the thermal radiation detection system 100. As the output generated by the infrared sensor element 104 can be dependent on operational temperature, the temperature sensing circuit can be configured to generate a signal that correlates to the temperature of the infrared sensor element 104.

FIG. 2 schematically depicts another thermal radiation detection system 200 in accordance with an example embodiment. This thermal radiation detection system 200 is similar to the thermal radiation detection system 100, as it includes at least one infrared sensor element 204 that is positioned proximate to a temperature sensor 206. Responsive to detected infrared radiation 214 from an article 212, the infrared sensor element 204 can provide an output to an amplifier 202. The amplifier 202 can convert the current output from the infrared sensor element 204 to an output voltage. A signal processing circuit 208 can receive the output voltage from the amplifier 202 along with a signal from the temperature sensor 206. The signal processing circuit 208 can, in turn, generate an output signal 210 that can be usable by an imaging system, or other suitable system.

In this embodiment, however, the thermal radiation detection system 200 includes a cooling circuit that includes a thermoelectric cooler 216 that is positioned proximate to the infrared sensor element 204. The thermoelectric cooler 216 is configured to generally regulate an operational temperature of the infrared sensor element 204. In accordance with various implementations, the thermoelectric cooler 216 is configured to regulate the operational temperature of the infrared sensor element 204 to within a range of about 5° C to about 40° C, specifically reciting all 1° C increments within the above-recited range and all ranges formed therein or thereby. According to an aspect of the invention, the thermoelectric cooler 216 is configured to regulate the operational temperature of the infrared sensor element 204 to a range of about 15° C to about 24° C, specifically reciting all 1° C increments within the above-recited range and all ranges formed therein or thereby. As the signals generated by the infrared sensor element 204 can be temperature dependent, including a cooling circuit in the thermal radiation detection system 200 can help to control and limit feedback runaway and to maintain certain operational conditions for the infrared sensor element 204. Other cooling mechanisms may be implemented to accomplish the same result such as fan cooling or heat sinks, for example.

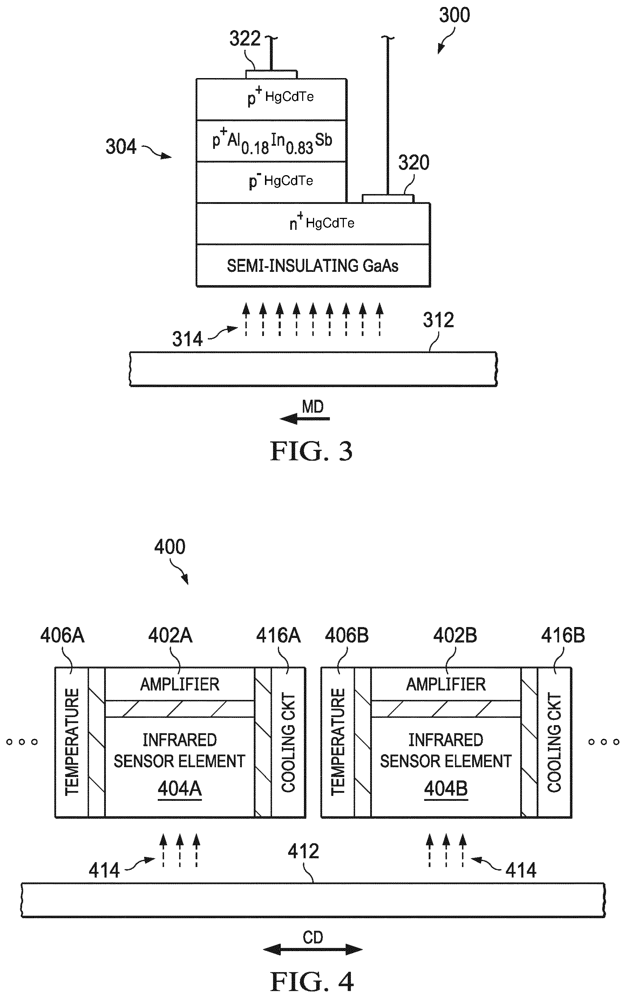

FIG. 3 provides a simplified view of an infrared sensor element 304 in accordance with an example embodiment. The infrared sensor element 304 can be a component of a thermal radiation detection system 300, for example. The infrared sensor element 304 can include a plurality of layers, including a semi-insulating Gallium arsenide (GaAs) substrate, in a plan view. A first electrode 320 can be electrically coupled to a first of the plurality of layers and a second electrode 322 can be electrically coupled to a second of the plurality of layers. The detected infrared wavelengths from an article 312, schematically shown as infrared radiation 314, are transmitted through the GaAs substrate to the first and second electrodes 320 and 322. Notably, the first and second electrodes 320 and 322 are not positioned on the same surface that is receiving the infrared radiation 314 from the article 312. This placement of the first and second electrodes 320 and 322 beneficially prevents them from interrupting or masking the infrared sensor, thereby creating a larger surface area for collecting the infrared radiation 314 and contributing to quick spectral response. Suitable alternatives to Gallium arsenide are Indium gallium arsenide (InGaAs, extended-InGaAs), or Germanium (Ge).

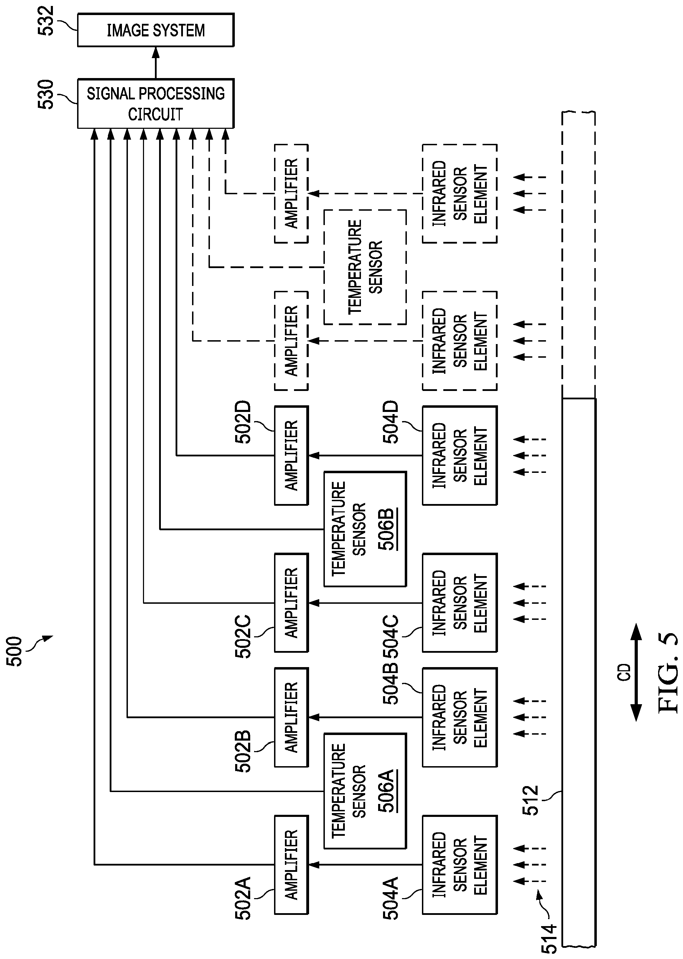

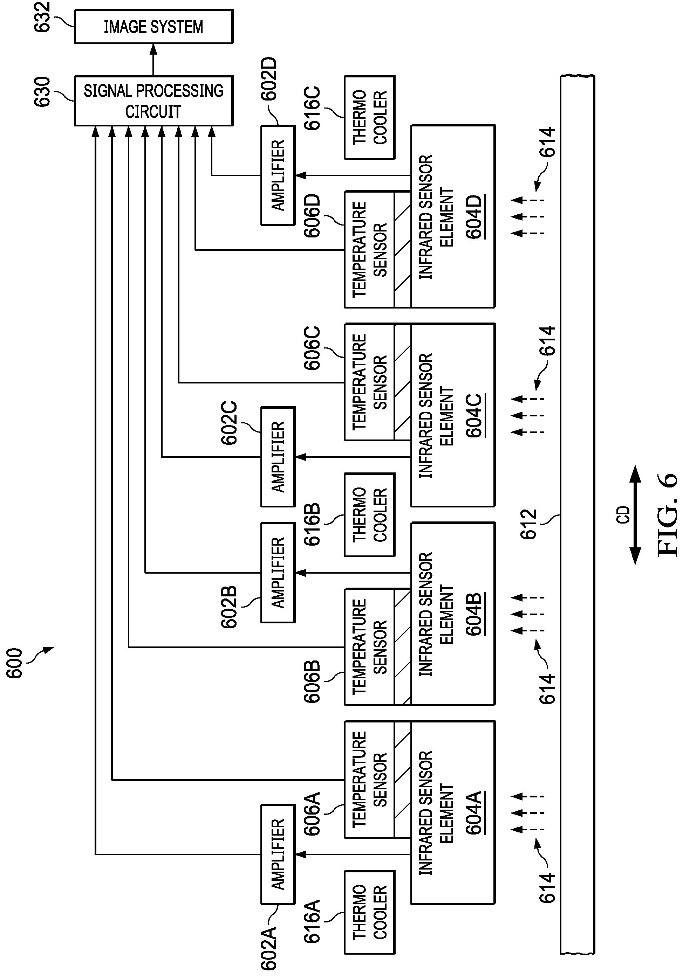

While FIGS. 1 and 2 depict single infrared sensor elements 104 and 204 for the purposes of illustration, in some embodiments a thermal radiation detection system can include an array of infrared sensor elements. FIG. 4 depicts a portion of a thermal radiation detection system 400 that includes an array of infrared sensor elements. While two infrared sensor elements 404A and 404B are shown for the purposes of illustration in FIG. 4, it is to be appreciated that the array can include any suitable number of infrared sensor elements. In some configurations, the array is sized such that it extends in a cross direction (CD) relative to an article 412 to detect infrared radiation 414 across substantially the entire width of the article 412. The array could as well be implemented to extend across only a portion of an article 412 to acquire representative signals without the need to extend across the entire article. As shown in FIG. 4, various components of the thermal radiation detection system 400 can be bonded to other components, such as through thermally conductive adhesives. In this regard, the infrared sensor element 404A is shown bonded to a temperature sensor 406A, an amplifier 402A, and a cooling circuit 416A. Similarly, the infrared sensor element 404B is shown bonded to a temperature sensor 406B, an amplifier 402B, and a cooling circuit 416B. While FIG. 4 depicts a one-to-one arrangement with regard to infrared sensor elements and the temperature sensor and the cooling circuit, this disclosure is not so limited. In other embodiments, as shown FIGS. 5 and 6, for example, the temperature sensor and the cooling circuit may have a one-to-many arrangement with regard to infrared sensor elements.

FIG. 5 schematically depicts a thermal radiation detection system 500 having an array of infrared sensor elements 504A-D. While four infrared sensor elements 504A-D are shown for the purposes of illustration, the thermal radiation detection system 500 can include any suitable number of infrared sensor elements, as indicated by the infrared sensor elements shown in dashed lines. The array of infrared sensor elements 504A-D can be arranged such that it generally extends in a cross direction (CD) across an article 512 to detect infrared radiation 514. In this embodiment, each infrared sensor element 504A-D is configured to provide an output signal to a respective amplifier 502A-D. Each of the amplifiers 502A-D is configured to provide its output to a signal processing circuit 530. Additionally, temperature sensors 506A and 506B are configured to provide signals to the signal processing circuit 530 responsive to the sensed temperature proximate to one or more of the infrared sensor elements 504A-D. In the illustrated embodiment, the temperature sensor 506A provides temperature information for infrared sensor elements 504A and 504B, and the temperature sensor 506B provides temperature information for infrared sensor elements 504C and 504D. As is to be appreciated, however, other arrangements can be used without departing from the scope of the present disclosure. Responsive to the signals received from the amplifiers 502A-D and the temperature sensors 506A and 506B, the signal processing circuit 530 can provide an output to an image system 532, or other suitable system.

FIG. 6 schematically depicts a thermal radiation detection system 600 having an array of infrared sensor elements 604A-D. While four infrared sensor elements 604A-D are shown for the purposes of illustration, the thermal radiation detection system 600 can include any suitable number of infrared sensor elements. The array of infrared sensor elements 604A-D can be arranged such that it generally extends in a cross direction (CD) across an article 612 to detect infrared radiation 614. In this embodiment, each infrared sensor elements 604A-D is configured to provide an output signal to a respective amplifier 602A-D. Each of the amplifiers 602A-D is configured to provide its output to a signal processing circuit 630. In this embodiment, temperature sensors 606A-606D are thermally bonded to respective infrared sensor elements 604A-D. The temperature sensors 606A-606D are configured to provide signals to the signal processing circuit 630 responsive to the sensed temperature proximate to the infrared sensor elements 604A-D. The thermal radiation detection system 600 also includes thermoelectric coolers 616A-616C. The thermoelectric coolers 616A-616C are operative to regulate the operational temperature of the infrared sensor elements 604A-D to within a range of about 5° C to about 40° C, for example, specifically reciting all 1° C increments within the above-recited range and all ranges formed therein or thereby. Responsive to the signals received from the amplifiers 602A-D and the temperature sensors 606A-606D, the signal processing circuit 630 can provide an output to an image system 632, or other suitable system.

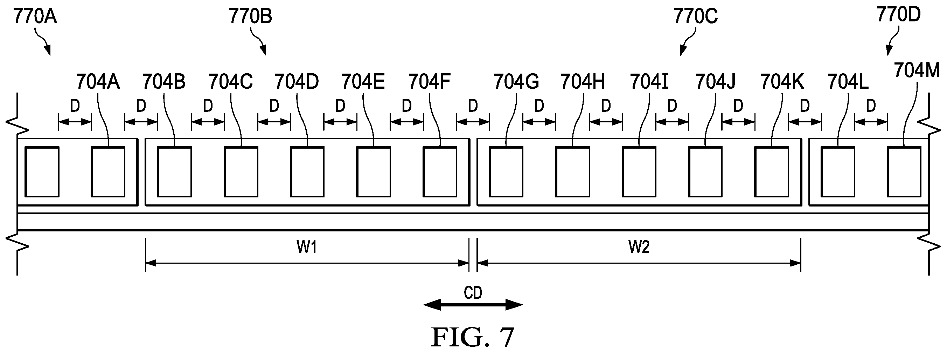

FIG. 7 schematically illustrates the placement of a plurality of arrays 770A-770D, each of which comprise infrared sensor elements arranged linearly. As shown, the illustrated portion of the array 770A includes infrared sensor element 704A, the array 770B includes infrared sensor elements 704B-704F, the array 770C includes infrared sensor elements 704G-704K, and the array 770D includes infrared sensor elements 704L-M. The arrays 770A-770D can be modular, such that any suitable number of arrays can be placed side by side to provide the desired width. As shown, each infrared sensor element with an array is equally spaced from adjacently infrared sensor elements, as shown by distance "D". Furthermore, the distance "D" is also maintained between the outermost infrared sensor elements of adjacently positioned arrays. By way of example, the infrared sensor element 704A of the array 770A is separated by a distance of "D" from the infrared sensor element 704B of the array 770B. Thus, from a data collection perspective, the imaging in a cross direction (CD) can be generally uniform across the entire article, even if a plurality of arrays of infrared sensor elements are placed side by side. Further, while the width of the arrays can vary (shown as W1 and W2 in FIG. 7), in some embodiments the width of the array is in the range of 10mm to 200mm. In some embodiments, each of the arrays has a width of 100mm.

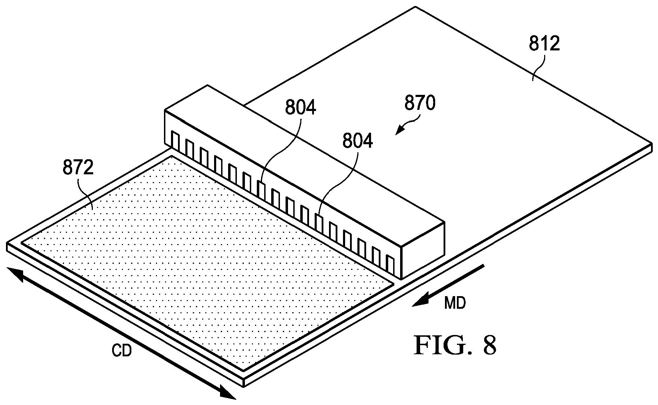

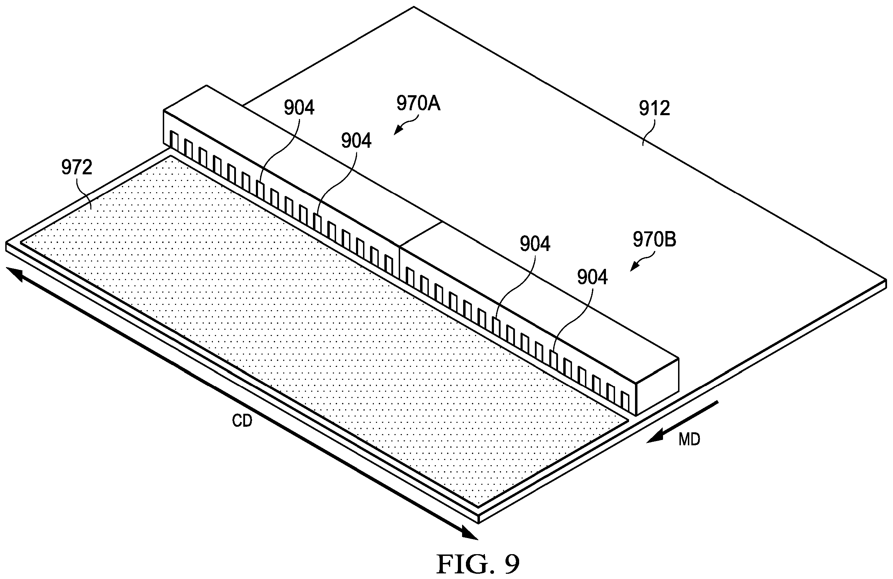

FIG. 8 is a simplified isometric view of an article 812 moving in a machine direction (MD) relative to an array 870 of infrared sensor elements 804 and in close proximity to article 812 as is typical of a contact image sensor (CIS) or linescan application. In one embodiment, close proximity of no more than 10cm from an article 812 ensures that the space requirements for the array 870 is minimized. In another embodiment, close proximity of no more than 30cm from an article 812 ensures that the infrared energy focuses on minimum number of sensing elements 804 at a time. Ideally the infrared energy from any point on article 812 is incident on only a single sensing element 804. In some embodiments, the infrared energy from any point on article 812 may be incident on a plurality of sensing elements 804 when the cross machine direction resolution is of less importance. As shown, the infrared sensor elements 804 are linearly positioned such that they collect infrared radiation from a scan area 872. Depending on the article 812 and the width of the array 870, the scan area 872 can generally extend across the entire article 812, or a portion of the article 812. FIG. 9 is a simplified isometric view of an article 912 moving in a machine direction (MD) relative to a plurality of arrays 970A and 970B, each of which includes a plurality of infrared sensor elements 904. By positioning the arrays 970A and 970B side by side, they can collect infrared radiation from a scan area 972 that generally extends across the entire article 912, or a portion of the article 912.

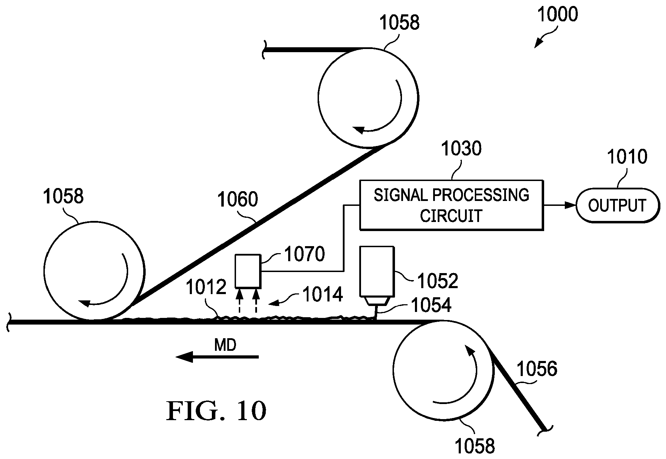

Thermal radiation detection systems in accordance with the present disclosure can beneficially be deployed at positions along a manufacturing process, including positions that are relatively confined. FIG. 10 schematically depicts a simplified manufacturing process incorporating a thermal radiation detection system 1000. While the manufacturing process depicted in FIG. 10 is a converting process for webs of materials, it is to be appreciated that the thermal radiation detection system can be used with a wide variety of different type of manufacturing processes. Thus, while webs are shown as the article of manufacture in FIG. 10, in other embodiments the web can be any of, for example, a substrate, a bottle, a package, a component of machinery, an elastic, an adhesive, an absorbent gelling material (AGM), a printing, a chemical additive, a lotion, and a volatile composition. Further, while FIG. 10 schematically depicts joining webs with an adhesive, other manufacturing process that can utilize thermal radiation detection systems in accordance with the present disclosure include processing for seaming the article, heat bonding the article, pressure welding the article, cohesive bonding the article, and so forth.

A first web of material 1056 and a second web of material 1060 are shown being joined by an adhesive 1054 dispensed from an applicator 1052. Due to the orientation of the rollers 1058, as well as other components as may be required, the available area to place an array 1070 of infrared sensor elements which is downstream of the applicator 1052 is quite confined. Nevertheless, due to the configuration of the thermal radiation detection system 1000, the array 1070 can be placed appropriately to receive infrared radiation 1014 from an article 1012. While not shown in FIG. 10, it is to be appreciated that one or more temperature sensors can also be associated with the array 1070. In some configurations, one or more thermoelectric coolers, or other types of cooling systems, can also be associated with the array 1070. A signal processing circuit 1030 can receive signaling based on the infrared radiation 1014 and the temperature of the infrared sensor elements in the array 1070. The signal processing circuit 1030 can be any of an application-specific integrated circuit, a field programmable gate array, a central processing unit, and a graphics processing unit, for example. An output 1010 of the signal processing circuit 1030 can be useable by, for example, a data acquisition system, an industrial computer control system, an imaging system, among a variety of other systems or processes.

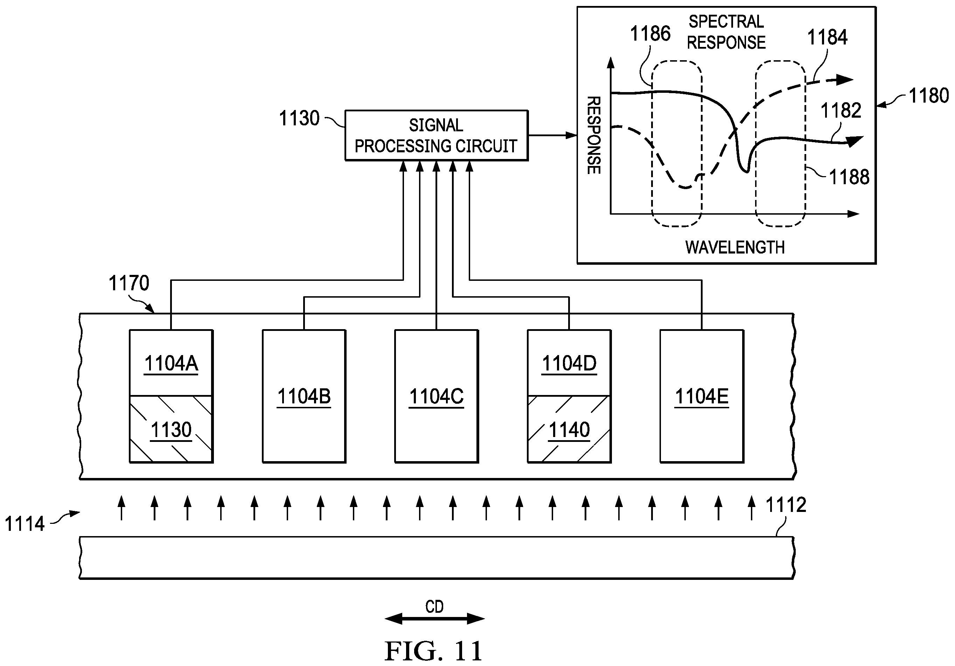

Furthermore, a thermal radiation detection system in accordance with the present disclosure can be configured to function as a spectroscopy sensor. FIG. 11 is simplified thermal radiation detection system that comprises a plurality of infrared sensor elements 1104A-1104E that are positioned to receive incident radiation 1114 from an article 1112. Similar to previously described embodiments, one or more temperature sensors, amplifiers, and optionally one or more thermoelectric coolers, can be associated with the infrared sensor elements 1104A-1104E. A first notch filter 1130 can be positioned proximate to a first infrared sensor element 1104A and a second notch filter 1140 can be positioned proximate to a second infrared sensor element 1104D. As schematically shown in the spectral response chart 1180, the notch filters 1130 and 1140 allow for the analysis of the spectral response in particular bands. By way of example, a first infrared sensor element 1104A allows for the analysis of the spectral response in a first band 1186 and the second infrared sensor element 1104D allows for the analysis of the spectral response in a second band 1188. As such, the spectral response of a first material 1182 in each of the first and second bands 1186 and 1188 can be compared to the spectral response of a second material 1184 in each of the first and second bands 1186 and 1188. Using these comparisons, certain determinations regarding the first and second materials 1182 and 1184 can be made. For example, if the spectral response is high in the first band 1186 and low in the second band 1188, it could indicate the material is an absorbent gelling material (AGM). Comparatively, if the spectral response is low in the first band 1186 and high in the second band 1188, it could indicate the material is an adhesive.

The dimensions and values disclosed herein are not to be understood as being strictly limited to the exact numerical values recited. Instead, unless otherwise specified, each such dimension is intended to mean both the recited value and a functionally equivalent range surrounding that value. For example, a dimension disclosed as "40 mm" is intended to mean "about 40 mm."

## Claims

1. A method for inspecting an article manufacturing process comprises
a) positioning a thermal radiation detection system (100) proximate to a manufacturing process,
wherein the thermal radiation detection system (100), comprises:
a plurality of infrared sensor elements (104) arranged as an array, each of the plurality of infrared sensor elements (104) comprising a semiconductor selected from a mercury-cadmium-telluride, HgCdTe,-based photodiode infrared detector or an Indium Arsenide, InAs,-based photodiode infrared detector configured to generate an output responsive to detected infrared wavelengths;
a temperature sensing circuit (106), the temperature sensing circuit configured to generate signals correlated to temperatures of one or more of the plurality of infrared sensor elements (104); and
a signal processing circuit (108), the signal processing circuit (108) configured to generate a signal (110) usable by an imaging system based on the signals generated by the temperature sensing circuit (106) and output based on the infrared sensor elements (104);
wherein the thermal radiation detection system (100) further comprises a cooling circuit, the cooling circuit configured to regulate an operational temperature of the plurality of infrared sensor elements (104);
wherein the cooling circuit comprises a thermoelectric cooler (216), the thermoelectric cooler (216) being configured to regulate the operational temperature of the plurality of infrared sensor elements (104) to a range of about 5° C to about 24° C
b) advancing an article (112) past the plurality of infrared sensor elements (104) subsequent to the manufacturing process, and
c) identifying characteristics of the manufacturing process based on the signal (110) from the signal processing circuit (108).

2. The method of claim 1, further comprising an amplifier (102) circuit, the amplifier (102) configured to convert the current outputs from a plurality of infrared sensor elements (104) to output voltages, wherein the amplifier circuit (102) comprises a transimpedance amplifier.

3. The method of any of the preceding claims, wherein the signal processing circuit (108) comprises any of: an application-specific integrated circuit, a field programmable gate array, a central processing unit, and a graphics processing unit.

4. The method of any of the preceding claims, wherein the temperature sensing circuit comprises one or more temperature sensing device, wherein the one or more temperature sensing device is a negative temperature coefficient thermistor, a thermocouple, an infrared sensitive photodiode, or a resistance temperature detector.

5. The method of claim 4, wherein each of the plurality of infrared sensor elements (104) is associated with a respective transimpedance amplifier and a respective temperature sensing device.

6. The method of any of the preceding claim, comprising a plurality of thermoelectric coolers (216), wherein each of the plurality of thermoelectric coolers (216) are positioned to regulate the operational temperature of a subset of the plurality of infrared sensor elements (104).

7. The method of any of the preceding claims, wherein the array comprises more than 10 infrared sensor elements (104) and preferably the width of the array is greater than 10cm.

8. The method of any of the preceding claims, wherein the plurality of infrared sensor elements (104) arranged as the array is a first plurality of infrared sensor elements (104) arranged as a first linear array and further comprising a second plurality of infrared sensor elements (104) arranged as a second linear array.

9. The method of claim 8, wherein:
each infrared sensor element (104) of the first plurality of infrared sensor elements (104) is equally spaced apart from adjacent infrared sensors in the first linear array; and
each infrared sensor element (104) of the second plurality of infrared sensor elements (104) is equally spaced apart from adjacent infrared sensors in the second linear array.

10. The method of either of claims 8 or 9 , wherein the first linear array is provided as a first modular array and the second linear array is provided as a second modular array, wherein when the first modular array is positioned immediately adjacent to and in-line with the second modular array, an outermost infrared sensor element of the first linear array is adjacent to an outermost infrared sensor element of the second linear array, and wherein a distance from the outermost infrared sensor element of the first linear array to the outermost infrared sensor element (104) of the second linear array is equal to the spacing between adjacent infrared sensor elements (104) of both the first linear array and the second linear array.

11. The method of any of the preceding claims, wherein the detected infrared wavelengths are 4 µm (microns) to 14 µm (microns).

12. The method of any of the preceding claims, wherein the mercury-cadmium-telluride, HgCdTe,-based photodiode infrared detector or the Indium Arsenide, InAs,-based photodiode infrared detector comprises:
a plurality of layers comprising a semi-insulating Gallium arsenide, GaAs, substrate in a plan view;
a first electrode (320) electrically coupled to a first of the plurality of layers and a second electrode (322) electrically coupled to a second of the plurality of layers; and
wherein the detected mid-infrared wavelengths are transmitted through the GaAs substrate to the first (320) and second electrodes (322).

13. The method of any of the preceding claims, wherein the article (112) comprises any of a web, a substrate, a bottle, a package, a component of machinery, an elastic, an adhesive, an absorbent gelling material (AGM), a printing, a chemical additive, a lotion, and a volatile composition.

14. The method of any of the preceding claims, wherein the manufacturing process comprises any of an application of an adhesive to the article (112), seaming the article, heat bonding the article, pressure welding the article, and cohesive bonding the article.

15. The method of any of the preceding claims, wherein the thermal radiation imaging system (100) is positioned within 10 cm of a surface of the article (112).

## Patentansprüche

1. Verfahren zum Überprüfen eines Artikelherstellungsverfahrens umfasst
a) Positionieren eines Wärmestrahlungsdetektionssystems (100) nahe an einem Herstellungsverfahren,
wobei das Wärmestrahlungsdetektionssystem (100) umfasst:
eine Vielzahl von Infrarotsensorelementen (104), die als eine Anordnung angeordnet sind, jedes der Vielzahl von Infrarotsensorelementen (104) umfassend einen Halbleiter, der aus einem auf Quecksilber-Cadmium-Tellurid, HgCdTe, basierenden Photodiodeninfrarotdetektor oder einem auf Indiumarsenid, InAs, basierenden Photodiodeninfrarotdetektor, der konfiguriert ist, um eine Ausgabe als Reaktion auf detektierte Infrarotwellenlängen zu erzeugen, ausgewählt ist;
einen Temperaturerfassungskreislauf (106), wobei der Temperaturerfassungskreislauf konfiguriert ist, um Signale zu erzeugen, die mit Temperaturen von einem oder mehreren der Vielzahl von Infrarotsensorelementen (104) korrelieren; und
einen Signalverarbeitungskreislauf (108), wobei der Signalverarbeitungskreislauf (108) konfiguriert ist, um ein Signal (110), das durch ein Bildgebungssystem verwendbar ist, basierend auf den Signalen zu erzeugen, die durch den Temperaturerfassungskreislauf (106) erzeugt und basierend auf den Infrarotsensorelementen (104) ausgegeben werden;
wobei das Wärmestrahlungsdetektionssystem (100) ferner einen Kühlkreislauf umfasst, wobei der Kühlkreislauf konfiguriert ist, um eine Betriebstemperatur der Vielzahl von Infrarotsensorelementen (104) zu regulieren;
wobei der Kühlkreislauf einen thermoelektrischen Kühler (216) umfasst, wobei der thermoelektrische Kühler (216) konfiguriert ist, um die Betriebstemperatur der Vielzahl von Infrarotsensorelementen (104) auf einen Bereich von etwa 5 °C bis etwa 24 °C zu regeln
b) Vorbeiführen eines Artikels (112) an der Vielzahl von Infrarotsensorelementen (104) nach dem Herstellungsverfahren und
c) Identifizieren von Merkmalen des Herstellungsverfahrens basierend auf dem Signal (110) von dem Signalverarbeitungskreislauf (108).

2. Verfahren nach Anspruch 1, ferner umfassend einen Verstärker(102)-Kreislauf, wobei der Verstärker (102) konfiguriert ist, um die Stromausgaben von einer Vielzahl von Infrarotsensorelementen (104) in Ausgabespannungen umzuwandeln, wobei der Verstärkerkreislauf (102) einen Transimpedanzverstärker umfasst.

3. Verfahren nach einem der vorstehenden Ansprüche, wobei der Signalverarbeitungskreislauf (108) ein beliebiges umfasst von: einer anwendungsspezifischen integrierten Schaltung, einem feldprogrammierbaren Gatterfeld, einer Zentraleinheit und einer Grafikverarbeitungseinheit.

4. Verfahren nach einem der vorstehenden Ansprüche, wobei der Temperaturerfassungskreislauf eine oder mehrere Temperaturerfassungsvorrichtungen umfasst, wobei die eine oder die mehreren Temperaturerfassungsvorrichtungen ein Thermistor mit negativem Temperaturkoeffizienten, ein Thermopaar, eine infrarotempfindliche Fotodiode oder ein Widerstandsthermometer ist.

5. Verfahren nach Anspruch 4, wobei jedes der Vielzahl von Infrarotsensorelementen (104) mit einem jeweiligen Transimpedanzverstärker und einer jeweiligen Temperaturerfassungsvorrichtung verknüpft ist.

6. Verfahren nach einem vorstehenden Anspruch, umfassend eine Vielzahl von thermoelektrischen Kühlern (216), wobei jeder der Vielzahl von thermoelektrischen Kühlern (216) positioniert ist, um die Betriebstemperatur einer Untergruppe der Vielzahl von Infrarotsensorelementen (104) zu regulieren.

7. Verfahren nach einem der vorstehenden Ansprüche, wobei die Anordnung mehr als 10 Infrarotsensorelemente (104) umfasst und vorzugsweise die Breite der Anordnung größer als 10 cm ist.

8. Verfahren nach einem der vorstehenden Ansprüche, wobei die Vielzahl von Infrarotsensorelementen (104), die als die Anordnung angeordnet sind, eine erste Vielzahl von Infrarotsensorelementen (104) ist, die als eine erste lineare Anordnung angeordnet sind, und ferner umfassend eine zweite Vielzahl von Infrarotsensorelementen (104), die als eine zweite lineare Anordnung angeordnet sind.

9. Verfahren nach Anspruch 8, wobei:
jedes Infrarotsensorelement (104) der ersten Vielzahl von Infrarotsensorelementen (104) von benachbarten Infrarotsensoren in der ersten linearen Anordnung gleichmäßig beabstandet ist; und
jedes Infrarotsensorelement (104) der zweiten Vielzahl von Infrarotsensorelementen (104) von benachbarten Infrarotsensoren in der zweiten linearen Anordnung gleichmäßig beabstandet ist.

10. Verfahren nach einem der Ansprüche 8 oder 9, wobei die erste lineare Anordnung als eine erste modulare Anordnung bereitgestellt ist und die zweite lineare Anordnung als eine zweite modulare Anordnung bereitgestellt ist, wobei, wenn die erste modulare Anordnung unmittelbar benachbart an und in Reihe mit der zweiten modularen Anordnung positioniert ist, ein äußerstes Infrarotsensorelement der ersten linearen Anordnung sich benachbart an ein äußerstes Infrarotsensorelement der zweiten linearen Anordnung befindet und wobei ein Abstand von dem äußersten Infrarotsensorelement der ersten linearen Anordnung zu dem äußersten Infrarotsensorelement (104) der zweiten linearen Anordnung gleich dem Zwischenraum zwischen benachbarten Infrarotsensorelementen (104) sowohl der ersten linearen Anordnung als auch der zweiten linearen Anordnung ist.

11. Verfahren nach einem der vorstehenden Ansprüche, wobei die detektierten Infrarotwellenlängen 4 µm (Mikrometer) 14 µm (Mikrometer) betragen.

12. Verfahren nach einem der vorstehenden Ansprüche, wobei der auf Quecksilber-Cadmium-Tellurid, HgCdTe, basierende Photodiodeninfrarotdetektor oder der auf Indiumarsenid, InAs, basierende Photodiodeninfrarotdetektor umfasst:
eine Vielzahl von Schichten, umfassend ein halbisolierendes Galliumarsenidsubstrat, GaAs-Substrat, in einer Draufsicht;
eine erste Elektrode (320), die mit einer ersten der Vielzahl von Schichten elektrisch gekoppelt ist, und eine zweite Elektrode (322), die mit einer zweiten der Vielzahl von Schichten elektrisch gekoppelt ist; und
wobei die detektierten Mittelinfrarotwellenlängen durch das GaAs-Substrat zu der ersten (320) und der zweiten Elektrode (322) übertragen werden.

13. Verfahren nach einem der vorstehenden Ansprüche, wobei der Artikel (112) ein beliebiges von einer Bahn, einem Substrat, einer Flasche, einer Verpackung, einem Maschinenbestandteil, einem Gummiband, einem Klebstoff, einem Absorptionsgeliermaterial (AGM), einem Druck, einem chemischen Zusatzstoff, einer Lotion und einer flüchtigen Zusammensetzung umfasst.

14. Verfahren nach einem der vorstehenden Ansprüche, wobei das Herstellungsverfahren ein beliebiges von einer Anwendung eines Klebstoffs auf den Artikel (112), einem Säumen des Artikels, einem Heißkleben des Artikels, einem Pressschweißen des Artikels und einem Kohäsionsbinden des Artikels umfasst.

15. Verfahren nach einem der vorstehenden Ansprüche, wobei das Wärmestrahlungsbildgebungssystem (100) innerhalb von 10 cm von einer Oberfläche des Artikels (112) positioniert ist.

## Revendications

1. Procédé d'inspection d'un processus de fabrication d'article comprenant
a) le positionnement d'un système de détection de rayonnement thermique (100) à proximité d'un processus de fabrication,
dans lequel le système de détection de rayonnement thermique (100) comprend :
une pluralité d'éléments de capteur infrarouge (104) agencés en réseau, chacun de la pluralité d'éléments de capteur infrarouge (104) comprenant un semi-conducteur choisi parmi un détecteur infrarouge à photodiode à base de mercure-cadmium-telluride, HgCdTe, ou un détecteur infrarouge à photodiode à base d'arséniure d'indium, InAs, configuré pour générer une sortie en réponse aux longueurs d'onde infrarouges détectées ;
un circuit de détection de température (106), le circuit de détection de température étant configuré pour générer des signaux corrélés à des températures d'un ou plusieurs parmi la pluralité d'éléments de capteur infrarouge (104) ; et
un circuit de traitement de signal (108), le circuit de traitement de signal (108) étant configuré pour générer un signal (110) utilisable par un système d'imagerie en fonction des signaux générés par le circuit de détection de température (106) et délivré en sortie en fonction des éléments de capteur infrarouge (104) ;
dans lequel le système de détection de rayonnement thermique (100) comprend en outre un circuit de refroidissement, le circuit de refroidissement étant configuré pour réguler une température de fonctionnement de la pluralité d'éléments de capteur infrarouge (104) ;
dans lequel le circuit de refroidissement comprend un refroidisseur thermoélectrique (216), le refroidisseur thermoélectrique (216) étant configuré pour réguler la température de fonctionnement de la pluralité d'éléments de capteur infrarouge (104) sur une plage d'environ 5° C à environ 24° C
b) l'avancement d'un article (112) au-delà de la pluralité d'éléments de capteur infrarouge (104) après le processus de fabrication, et
c) l'identification de caractéristiques du processus de fabrication en fonction du signal (110) provenant du circuit de traitement de signal (108).

2. Procédé selon la revendication 1, comprenant en outre un circuit d'amplification (102), l'amplificateur (102) étant configuré pour convertir les sorties de courant d'une pluralité d'éléments de capteur infrarouge (104) en tensions de sortie, dans lequel le circuit d'amplification (102) comprend un amplificateur à transimpédance.

3. Procédé selon l'une quelconque des revendications précédentes, dans lequel le circuit de traitement de signal (108) comprend l'un quelconque parmi : un circuit intégré spécifique à une application, un réseau de portes programmable par l'utilisateur, une unité centrale de traitement et une unité de traitement graphique.

4. Procédé selon l'une quelconque des revendications précédentes, dans lequel le circuit de détection de température comprend un ou plusieurs dispositifs de détection de température, dans lequel le ou les dispositifs de détection de température sont un thermistor à coefficient de température négatif, un thermocouple, une photodiode sensible à l'infrarouge ou un détecteur de température à résistance.

5. Procédé selon la revendication 4, dans lequel chacun de la pluralité d'éléments de capteur infrarouge (104) est associé à un amplificateur à transimpédance respectif et à un dispositif de détection de température respectif.

6. Procédé selon l'une quelconque revendication précédente, comprenant une pluralité de refroidisseurs thermoélectriques (216), dans lequel chacun de la pluralité de refroidisseurs thermoélectriques (216) est positionné pour réguler la température de fonctionnement d'un sous-ensemble de la pluralité d'éléments de capteur infrarouge (104).

7. Procédé selon l'une quelconque des revendications précédentes, dans lequel le réseau comprend plus de 10 éléments de capteur infrarouge (104) et de préférence la largeur du réseau est supérieure à 10 cm.

8. Procédé selon l'une quelconque des revendications précédentes, dans lequel la pluralité d'éléments de capteur infrarouge (104) agencés en réseau est une première pluralité d'éléments de capteur infrarouge (104) agencés en tant que premier réseau linéaire et comprenant en outre une seconde pluralité d'éléments de capteur infrarouge (104) agencés en tant que second réseau linéaire.

9. Procédé selon la revendication 8, dans lequel :
chaque élément de capteur infrarouge (104) de la première pluralité d'éléments de capteur infrarouge (104) est également espacé de capteurs infrarouges adjacents dans le premier réseau linéaire ; et
chaque élément de capteur infrarouge (104) de la seconde pluralité d'éléments de capteur infrarouge (104) est également espacé de capteurs infrarouges adjacents dans le second réseau linéaire.

10. Procédé selon l'une ou l'autre des revendications 8 ou 9, dans lequel le premier réseau linéaire est fourni en tant que premier réseau modulaire et le second réseau linéaire est fourni en tant que second réseau modulaire, dans lequel lorsque le premier réseau modulaire est positionné immédiatement adjacent au second réseau modulaire et en ligne avec celui-ci, un élément de capteur infrarouge le plus à l'extérieur du premier réseau linéaire est adjacent à un élément de capteur infrarouge le plus à l'extérieur du second réseau linéaire, et dans lequel une distance entre l'élément de capteur infrarouge le plus à l'extérieur du premier réseau linéaire et l'élément de capteur infrarouge le plus à l'extérieur (104) du second réseau linéaire est égale à l'espacement entre des éléments de capteur infrarouge adjacents (104) à la fois du premier réseau linéaire et du second réseau linéaire.

11. Procédé selon l'une quelconque des revendications précédentes, dans lequel les longueurs d'onde infrarouges détectées sont de 4 µm (micromètres), 14 µm (micromètres).

12. Procédé selon l'une quelconque des revendications précédentes, dans lequel le détecteur infrarouge à photodiodes à base de mercure-cadmium-tellurure HgCdTe ou le détecteur infrarouge à photodiodes à base d'arséniure d'indium, InAs, comprend :
une pluralité de couches comprenant un substrat d'arséniure de gallium semi-isolant, GaAs, dans une vue en plan ;
une première électrode (320) couplée électriquement à une première de la pluralité de couches et une seconde électrode (322) couplée électriquement à une seconde de la pluralité de couches ; et
dans lequel les longueurs d'onde en infrarouge moyen détectées sont transmises par le substrat GaAs aux première (320) et seconde électrodes (322).

13. Procédé selon l'une quelconque des revendications précédentes, dans lequel l'article (112) comprend l'un quelconque parmi bande, substrat, bouteille, conditionnement, composant de machine, élastique, adhésif, matériau gélifiant absorbant (AGM), impression, additif chimique, lotion et composition volatile.

14. Procédé selon l'une quelconque des revendications précédentes, dans lequel le processus de fabrication comprend l'un quelconque parmi une application d'un adhésif sur l'article (112), la couture de l'article, la liaison par la chaleur de l'article, le soudage sous pression de l'article, et la liaison cohésive de l'article.

15. Procédé selon l'une quelconque des revendications précédentes, dans lequel le système d'imagerie par rayonnement thermique (100) est positionné dans les 10 cm d'une surface de l'article (112).
